**Europäisches Patentamt**

**European Patent Office**

**Office européen des brevets**

(11) Veröffentlichungsnummer: **0 261 334 B1**

# EUROPÄISCHE PATENTSCHRIFT

(45) Veröffentlichungstag der Patentschrift: **08.05.91**

(51) Int. Cl.5: **C23C 18/18**

(21) Anmeldenummer: **87110335.4**

(22) Anmeldetag: **17.07.87**

(54) **Verfahren zum haftfesten Galvanisieren von keramischen Materialien.**

(30) Priorität: **22.09.86 DE 3632513**

(43) Veröffentlichungstag der Anmeldung:
**30.03.88 Patentblatt 88/13**

(45) Bekanntmachung des Hinweises auf die
Patenterteilung:
**08.05.91 Patentblatt 91/19**

(84) Benannte Vertragsstaaten:
**BE CH DE ES FR GB IT LI LU NL SE**

(56) Entgegenhaltungen:
**FR-A- 2 449 663**

(73) Patentinhaber: **SCHERING AKTIENGESELL-
SCHAFT Berlin und Bergkamen
Müllerstrasse 170/178 Postfach 65 03 11
W-1000 Berlin 65(DE)**

(72) Erfinder: **Suhr, Harald, Prof.Dr.rer.nat.
Weissdornweg 2
W-7400 Tübingen(DE)**
Erfinder: **Oehr, Christian
Wintergasse 6
W-7403 Reusten(DE)**
Erfinder: **Feurer, Ernst
Ringstrasse 6
W-7400 Tübingen(DE)**

**Beschreibung**

Die Erfindung betrifft ein Verfahren zur haftfesten Galvanisierung von keramischen Materialien durch Konditionierung der Oberflächge in einer Glimmentladungszone unter der Einwirkung von Borhalogenid und anschließender Aktivierung und Metallabscheidung auf naßchemischem Wege.

Die Erfindung soll es insbesondere ermöglichen, Leiterbahnen hoher Güte und Genauigkeit auf Keramikplatten aus Aluminiumoxid herzustellen, wie sie für zahlreiche Anwendungen in der Elektronik gefordert werden.

Hierbei spielt die Haftfestigkeit des Metallüberzuges auf dem Keramik-Substrat eine wesentliche Rolle. Auf einer unbehandelten Keramikoberfläche ist sie so gering, daß sie den Anforderungen der Praxis nicht genügt. Es sind deshalb verschiedene Methoden beschrieben worden, durch eine Vorbehandlung der Keramik vor der Metallisierung bessere Haftfestigkeiten zu erreichen.

Am bekanntesten ist die Behandlung der Keramik-Gegenstände in Schmelzen von Alkalihydroxiden. Hierbei wird die Oberfläche soweit angelöst, daß nach entsprechender Aktivierung (zum Beispiel in palladiumhaltigen Lösungen) eine brauchbare chemische Metallisierung möglich ist. Nachteilig ist bei diesem Verfahren daß beim Entfernen der Gegenstände aus der Schmelze sehr viel Alkalihydroxid verschleppt wird. Hinzu kommt, daß diese aggressive Schmelze alle bekannten Tegelmaterialien mit Ausnahme von Platin stark angreift.

Eine Verbesserung stellt das Vorbehandlungsverfahren nach DE-OS 31 50 399.3 dar. Hierbei erfolgt die Behandlung in einer wässrigen Alkalihydroxid-Lösung bei vorzugsweise 80 - 120°C, doch müssen die Keramik-Gegenstände anschließend noch auf 300 - 600°C erhitzt werden, was zeit- und energieaufwendig ist.

Andere Methoden zur haftfesten Metallisierung von Keramik beruhen auf der Verwendung von metallhaltigen Pasten, die bei hohen Temperaturen unter Schutzgas oder in reduzierter Atmosphäre eingebrannt werden müssen. Hierbei handelt es sich ebenfalls um umständliche und aufwendige Verfahren.

Aufgabe der vorliegenden Erfindung ist es, Metallüberzüge mit hervorragender Haftfestigkeit auf Keramikoberflächen durch einen Arbeitsablauf zu erzeugen, der die Nachteile der bekannten Vorbehandlungsmethoden vermeidet. Dies wird dadurch erreicht, daß die Keramikgegenstände gemäß folgendem Arbeitsablauf behandelt werden:

1. Einbringen in eine Glimmentlagunszone unter Einwirkung von gasförmigen Borhalogeniden.
2. Tauchen in Wasser oder einer wässrigen Lösung von Säuren oder Alkalien zur Entfernung der auf der Keramikoberfläche verbliebenen reaktiven Halogenverbindungen.
3. Aktivieren der Keramikoberfläche, zum Beispiel durch Tauchen in edelmetallhaltige Lösungen.
4. Chemische Metallabscheidung auf der aktivierten Oberfläche, zum Beispiel Verkupfern oder Vernikkeln.

Anschließend können die Keramikgegenstände in bekannter Weise durch elektrolytische Metallabscheidung mit weiteren Metallüberzügen versehen werden.

Bei Anwendung des erfindungsmäßigen Verfahrens erhält man Haftfestigkeiten des Metallüberzuges, die durchschnittlich doppelt so hoch sind wie bei Keramikoberflächen, die nicht der Plasmabehandlung unterworfen wurden.

Es ist bekannt, Borhalogenide, insbesondere Bortrichlorid meist im Gemisch mit anderen Gasen zum Ätzen von Aluminium und Aluminiumlegierungen unter Einwirkung einer Glimmentladung zu verwenden.

Hierbei ist beabsichtigt, die natürliche Oxidschicht des Aluminiums zu durchbrechen und bestimmte Strukturen mit einer bestimmten Ätztiefe auf der Aluminiumoberfläche zu erzeugen. Diesen Verfahren sind keine Hinweise auf das haftfeste Metallisieren von Keramikgegenständen gemäß vorliegender Erfindung zu entnehmen.

Die folgenden Beispiele erläutern die Erfindung:

BEISPIEL 1 -

VERKUPFERUNG VON ALUMINIUMOXID-KERAMIK

Keramikplättchen der Größe 25 x 25 x 2 mm werden in einem Parallelplatten-Plasmareaktor mit einem Elektrodenabstand von 20 mm einer Plasma-Einwirkung unter folgenden Bedingungen ausgesetzt:

EP 0 261 334 B1

| Leistungsdichte | $1,6 \text{ Watt/cm}^2$ |
|---|---|
| Druck im Reaktor | 0,5 hPa |
| Frequenz | 13,56 MHz |
| Elektrodentemperatur | $150^{\circ}C$ |
| Reaktionsgas | Bortrichlorid |
| Einwirkungszeit im Plasma | 90 min |

Nach Beendigung der Plasmaeinwirkung werden die Keramikplättchen aus dem Reaktor entfernt und naßchemisch wie folgt weiterbehandelt:
- Tauchen in eine 10 %ige Lösung von Natriumhydroxid 80° C. Dauer 2 min.
- Tauchen in eine 1 %ige Lösung von Schwefelsäure in Wasser unter Zusatz von anionischen Tensiden. Raumtemperatur Dauer 1 min.
- Tauchen in eine Aktivatorlösung auf Basis von Palladiumchlorid/Zinnchlorid bei Raumtemperatur. Dauer 5 min.
- Verkupfern in einem chemischen Kupferbad bei 60° C, Dauer 50 min.

Nach dieser Behandlung sind die Keramikplättchen mit einer lückenlosen, gleichmäßigen Kupferschicht überzogen.

Zur Prüfung der Haftfestigkeit wird die Kupferschicht in einem schwefelsauren Kupferbad eletrolytisch auf 25 μm Schichtdicke verstärkt und einem Stirnabreißtest unterzogen. Es werden Haftfestigkeitswerte von 125 - 130 kg/cm² gefunden.

Zum Vergleich werden Keramikplättchen ohne Plasma-Vorbehandlung in gleicher Weise aktiviert und verkupfert. Die Haftfestigkeit nach dem Stirnabreißtest beträgt hierbei 67 kg/cm².


BEISPIEL 2 -


VERNICKELUNG VON ALUMINIUMNITRIDKERAMIK

Plättchen aus Aluminiumnitridkeramik der Abmessungen 50 x 50 x 3 mm werden einer Plasmaeinwirkung unter gleichen Bedingungen wie im Beispiel 1 ausgesetzt. Danach werden die Plättchen wie folgt weiterbehandelt:
- Tauchen in eine 2 %ige Lösung von Ammoniumhydroxid. Raumtemperatur, 2 min.
- Tauchen in eine Aktivatorlösung auf Basis von ionogenen Palladiumverbindungen bei 35° C, 5 min.
- Reduzieren der Palladiumverbindungen durch Tauchen in eine 0,5 %ige Lösung von Natriumborhydrid bei Raumtemperatur, 3 min.
- Vernickeln in einem chemischen Nickelbad bei 70° C, 15 min

Nach dieser Behandlung wird der Überzug in einem schwefelsauren Nickelbad elektrolytisch verstärkt. Der Stirnabreißtest zeigt Werte für die Haftfestigkeit von 110 kg/cm², während sie bei vernickelten Plättchen ohne Plasmavorbehandlung bei 50 - 60 kg/cm² liegen.

Die Plasmaeinwirkung auf die Substratoberfläche kann in weiten Grenzen variiert werden, ohne daß die deutliche Verbesserung der Haftfestigkeit darunter leidet. Im allgemeinen sollten folgende Arbeitsbedingungen eingehalten werden:

| Leistungsdichte | $0.3 - 2.0 \text{ Watt/cm}^2$ |
| Druck im Reaktor | $0.1 - 1.0$ hPa |
| Frequenz | Hochfrequenz oder Gleich-<br>spannung |
| Elektrodentemperatur | Raumtemperatur bis $250^\circ$C |
| Einwirkzeit | $10 - 150$ min |

Es ist auch möglich und häufig zweckmäßig, das Borhalogengas im Plasmareaktor durch Zumischen eines Trägergases zu verdünnen, um eine besonders gleichmäßige Einwirkung auf die Keramikoberfläche zu erzielen. Als Trägergas eignet sich zum Beispiel Argon oder Wasserstoff im Verhältnis 1 : 1 bis 5 : 1 zum Borhalogenid.

Wie bereits erwähnt, werden nach der Plasmaeinwirkung die Keramikgegenstände in Wasser oder in sauren beziehungsweise alkalischen Lösungen getaucht, um reaktive Halogenverbindungen (bei Verwendung von Bortrichlorid Chlorverbindungen) von der Oberfläche zu entfernen. Ohne die Tauchung würden diese Verbindungen bei der nachfolgenden Aktivierung des Edelmetall, zum Beispiel Palladium zum Halogenid oxidieren, das anschließend wieder reduziert werden muß.

## Ansprüche

1. Verfahren zum Metallisieren von keramischen Materialien mit hoher Haftfestigkeit, gekennzeichnet durch folgenden Arbeitsablauf:
   - Einwirkung von gasförmigen Borhalogeniden auf die Keramikoberfläche in einer Glimmentladungszone
   - Tauchen der Keramikgegenstände in alkalische, neutrale oder saure wässrige Lösungen
   - Aktivieren der Keramikgegenstände in Lösungen von Metallverbindungen, insbesondere Edelmetallverbindungen
   - Chemische Metallabscheidung auf der aktivierten Keramikoberfläche.

2. Verfahren nach Anspruch 1, dadurch gekennzeichnet, daß als Borhalogenid Bortrichlorid oder Bortrifluorid benutzt wird.

3. Verfahren nach Anspruch 1, dadurch gekennzeichnet, daß die Aktivierung in palladiumhaltigen Lösungen vorgenommen wird.

## Claims

1. Method for highly adhesive metal-plating of ceramic materials, characterized by the following sequence of operations:
   - action of boron halides in gaseous form on the ceramic surface in a glow discharge zone,
   - immersion of the ceramic articles in alkaline, neutral or acid solutions,
   - activation of the ceramic articles in metal compound solutions, in particular solutions of nobel metal compounds,
   - chemical metal deposition on the activated ceramic surface.

2. Method in accordance with Claim 1, characterized in that the boron halides used are boron trichloride or boron trifluoride.

3. Method in accordance with Claim 1, characterized in that activation is performed by means of solutions containing palladium.

**Revendications**

1. Procédé de métallisation de matériaux céramiques à bonne adhérence caractérisé par la suite des opérations suivantes:
   - action d'halogénures de bore sur la surface céramique dans une zone de décharge lumineuse,
   - immersion des articles céramiques dans des solutions alcalines, neutres ou acides,
   - activation des articles céramiques dans de solutions contenant des composés de métaux, plus particulièrement des composés de métaux précieux,
   - déposition de métaux par voie chimique sur la surface céramique activée.

2. Procédé suivant la révendication 1 caractérisé en ce que l'halogénure de bore utilisé est le trifluorure de bore ou le trichlorure de bore.

3. Procédé suivant la révendication 1 caractérisé en ce que l'activation a lieu dans des solutions contenant du palladium.